# EUROPEAN PATENT APPLICATION

(11) **EP 4 757 570 A2**
(43) Date of publication of application: **10.06.2026**
(21) Application number: 25219866.8
(22) Date of filing: 01.12.2025
(51) Int. Cl.: H10P 72/00

(54) **CONTROLLED ATMOSPHERE CHAMBER WITH NOVEL ARCHITECTURE FOR LOAD/UNLOAD**

(30) Priority: 06.12.2024 US 202463728959 P; 27.01.2025 US 202519037621
(71) Applicant: II-VI Delaware, Inc., Wilmington, DE 19890 (US)
(72) Inventor: WU, Chan, Wilmington, 19890 (US); RULE, Toby, Wilmington, 19890 (US)
(74) Representative: Schmidt, Christian

(57) **Abstract**

This disclosure describes systems and methods for an annealing chamber that reduces oxygen infiltration from ambient air during the loading and unloading of a wafer. The wafer annealing chamber has an auxiliary port that is perpendicular to a plurality of exhaust ports. When the loading door is open, the plurality of exhaust ports are closed, and a pressurized zone is generated adjacent to the auxiliary port, in a throat of the annealing chamber.

## Description

### CROSS REFERENCE TO RELATED APPLICATIONS

This application claims priority to and the benefit of U.S. Provisional Patent Application No. 63/728,959 entitled "CONTROLLED ATMOSPHERE CHAMBER WITH NOVEL ARCHITECTURE FOR LOAD/UNLOAD" filed December 6, 2024, which is hereby incorporated herein by reference in its entirety.

### BACKGROUND

Limitations and disadvantages of traditional methods and systems for laser annealing will become apparent to one of skill in the art, through comparison of such approaches with some aspects of the present method and system set forth in the remainder of this disclosure with reference to the drawings.

### BRIEF SUMMARY

Systems and methods for designing a controlled atmosphere chamber, substantially as illustrated by and/or described in connection with at least one of the figures, are set forth more completely in the claims.

### BRIEF DESCRIPTION OF THE DRAWINGS

FIG. 1 illustrates an example annealing chamber, in accordance with various example implementations of this disclosure.
FIG. 2 illustrates an example gas flow while a chamber door is closed, in accordance with various example implementations of this disclosure.
FIG. 3 illustrates an example gas flow while a chamber door is open, in accordance with various example implementations of this disclosure.

### DETAILED DESCRIPTION

The following discussion provides various examples of an annealing chamber. Such examples are non-limiting, and the scope of the appended claims should not be limited to the particular examples disclosed. In the following discussion, the terms "example" and "e.g." are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

The terms "comprises," "comprising," "includes," and/or "including," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Typical laser annealing chambers often face issues where oxygen from ambient air infiltrates the lasing chamber during wafer loading and unloading. This contamination allows debris to settle on the wafer, adversely affecting the annealing process. Load-lock hardware and controls can mitigate airflow. However, their cost, complexity, and maintenance requirements make them less viable solutions.

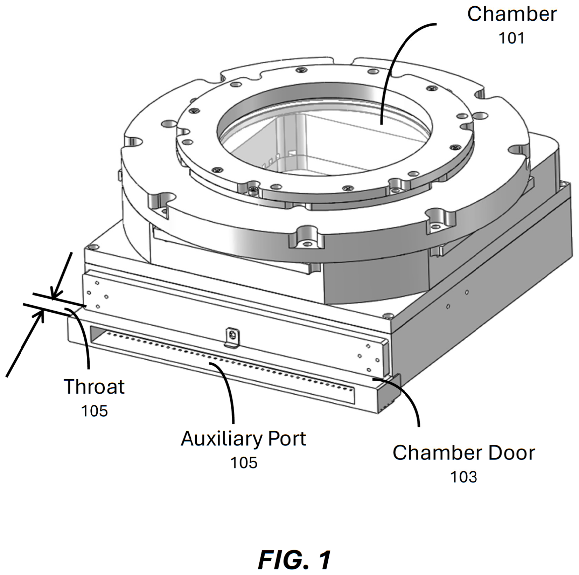

FIG. 1 illustrates an example annealing chamber in accordance with various implementations of this disclosure. The chamber design incorporates several features aimed at improving wafer processing efficiency, reducing oxygen ingress, and enhancing particulate removal.

The wafer annealing chamber 101 includes a chamber door 103 that opens an auxiliary port 105 that is adjacent to an extended throat 105. Unlike typical chambers, where the wafer is located close to the loading port, the disclosed chamber 101 features an extended throat 105 that is longer on the loading side compared to other lateral sides. This extended throat 105 is designed to maintain a pressure boundary even when the chamber is open for wafer loading and unloading, thereby preserving the inert environment inside the chamber.

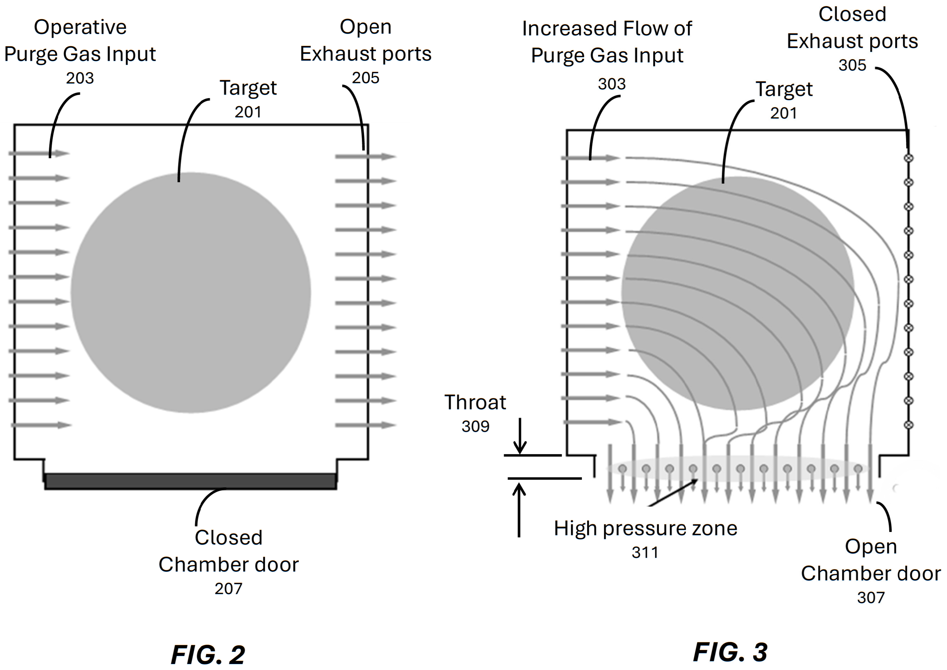

FIG. 2 illustrates an example gas flow within the chamber while the door is closed, according to various implementations of this disclosure.

Gas inlet ports 203 (e.g., with nozzle-shaped holes) may be positioned above the target wafer surface 201, creating laminar flow across the wafer 201. Exhaust ports 205 on the opposite side are open to prove effective debris removal. The exhaust ports 205 are typically larger than the inlet ports 203.

During lasing, the chamber door 207 remains closed, and laminar gas flow is maintained across the wafer 201, exiting through the exhaust ports 205. The chamber door is oriented perpendicular to the laminar gas flow, to minimize disruption of the flow dynamics.

In an example annealing process, nickel and silicon carbide, for example, may be heated to form nickel silicide. Byproducts such as vaporized carbon, excess nickel, and silicon may coalesce into particulates ranging from, for example, 0.01 µm to 1.0 µm. These particulates may be carried away by a laminar cross-flow of gas, which may have a velocity of 0.4 to 1.2 meters per second. Some particulates may settle on the wafer surface, chamber walls, exhaust piping, and filters. However, the design may minimize their accumulation through optimized flow dynamics.

FIG. 3 illustrates an example gas flow when the chamber door is open, according to various implementations of this disclosure.

The chamber door opens 307 to a narrow auxiliary port that enables the chamber to maintain a positive pressure 311, reduce air exchange and expedite chamber preparation for subsequent wafers. A continuous nitrogen gas flow may minimize oxygen ingress. The auxiliary port may be slot-shaped with a height, for example, under 20 mm.

The extended throat 309 design pushes the oxygen diffusion zone away from the main chamber. A reduced loading port, sized for wafer and fork access, combined with the extended throat 309, minimizes air exchange and preserves the chamber's inert environment. The throat dimensions may be, for example, greater than 200 mm wide, less than 20 mm tall, and greater than 20 mm deep, creating a high-pressure zone 311 just inside the opening that blocks inward movement of debris. A standby gas flow of, for example, 5-10 liters per minute through this auxiliary port may generate a positive pressure environment.

During loading and unloading, the gas flow velocity 303 over the wafer 201 may be increased, and the exhaust ports may be closed 305 to purge debris and prevent settling on the target 201. The high-velocity flow may exit through the open chamber door port 307, maintaining positive pressure and minimizing oxygen ingress. Additional purge gas ports may create a high-pressure zone 307 in the extended throat 309, further enhancing oxygen exclusion.

Additional flow enhancements may comprise varying gas and wafer surface temperatures and employing active gas chemistries, such as ammonia, to facilitate carbon removal and transport of post-reaction residues. Cooling the gas may optimize debris transport. Maintaining precise pressure control may provide consistent chamber conditions for high-throughput processing.

This disclosure may relate to the following implementations: This disclosure describes systems and methods for an annealing chamber that reduces oxygen infiltration from ambient air during the loading and unloading of a wafer. The wafer annealing chamber has an auxiliary port that is perpendicular to a plurality of exhaust ports. When the loading door is open, the plurality of exhaust ports are closed, and a pressurized zone is generated adjacent to the auxiliary port, in a throat of the annealing chamber.

The present application claims priority of US patent application 63/728,959 filed on December 6, 2024, and of US patent application 19/037,621 filed on January 27, 2025. The entire disclosure content of these applications is hereby incorporated herein by reference for all purposes.

In the following, a set of items is disclosed. The items are numbered to facilitate referencing the features of one item in other items. The items form part of the present disclosure and could be made subject to independent and/or dependent claims irrespective of what currently is claimed in the application. We note, however, that the scope of protection is defined by the appended claims, where the following items do not constitute claims. The items are:
1. A method, comprising:
   generating a laminar flow of a gas across a semiconductor wafer during a laser annealing process in a chamber, wherein the gas exits the chamber via a plurality of exhaust ports;
   closing the plurality of exhaust ports while a door of the chamber is open, wherein:
      the door of the chamber opens an auxiliary port,
      the auxiliary port is perpendicular to the plurality of exhaust ports, and
      a width of the auxiliary port is greater than a height of the auxiliary port; and increasing a flow of the gas to generate a pressurized zone in a throat adjacent to the
      auxiliary port.
2. The method of item 1, wherein the pressurized zone reduces oxygen ingress.
3. The method of item 1, wherein the chamber comprises a plurality of inlet ports.
4. The method of item 1, wherein the laminar flow comprises a velocity between 0.4 and 1.2 meters per second.
5. The method of item 1, wherein the method comprises loading and/or unloading the semiconductor wafer while the door of the chamber is open.
6. The method of item 1, wherein the height of the auxiliary port is less than 20 mm.
7. The method of item 1, wherein the gas comprises ammonia.
8. The method of item 1, wherein the method comprises cooling the gas.
9. The method of item 1, wherein a standby gas flow through the auxiliary port is 5-10 liter per min.
10. The method of item 1, wherein a pressure in the pressurized zone is determined according to the height of the door of the chamber.
11. A system, comprising:
   a chamber comprising a throat, a door, a target region, and a plurality of exhaust ports, wherein:
   during a laser annealing process, the plurality of exhaust ports are open and the chamber is configured to generate a laminar flow of a gas across the target region, and
   while the door is open, the plurality of exhaust ports are closed, a flow of the gas is increased, and the chamber is configured to generate a pressurized zone in the throat of the chamber, wherein:
      the door of the chamber opens an auxiliary port,
      the auxiliary port is perpendicular to the plurality of exhaust ports, and
      a width of the auxiliary port is greater than a height of the auxiliary port.
12. The system of item 11, wherein the pressurized zone reduces oxygen ingress.
13. The system of item 11, wherein the chamber comprises a plurality of inlet ports.
14. The system of item 11, wherein the laminar flow comprises a velocity between 0.4 and 1.2 meters per second.
15. The system of item 11, wherein the system is configured for loading and/or unloading a semiconductor wafer while the door of the chamber is open.
16. The system of item 11, wherein the height of the auxiliary port is less than 20 mm.
17. The system of item 11, wherein the gas comprises ammonia.
18. The system of item 11, wherein the chamber is configured to cool the gas.
19. The system of item 11, wherein a standby gas flow through the auxiliary port is 5-10 liter per min.
20. The system of item 11, wherein a pressure in the pressurized zone is determined according to the height of the door.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A method, comprising:
generating a laminar flow of a gas across a semiconductor wafer during a laser annealing process in a chamber, wherein the gas exits the chamber via a plurality of exhaust ports;
closing the plurality of exhaust ports while a door of the chamber is open, wherein:
the door of the chamber opens an auxiliary port,
the auxiliary port is perpendicular to the plurality of exhaust ports, and
a width of the auxiliary port is greater than a height of the auxiliary port; and increasing a flow of the gas to generate a pressurized zone in a throat adjacent to the
auxiliary port.

2. The method of claim 1, wherein the pressurized zone reduces oxygen ingress.

3. The method of any one of the preceding claims, wherein the chamber comprises a plurality of inlet ports.

4. The method of any one of the preceding claims, wherein the laminar flow comprises a velocity between 0.4 and 1.2 meters per second.

5. The method of any one of the preceding claims, wherein the method comprises loading and/or unloading the semiconductor wafer while the door of the chamber is open.

6. The method of any one of the preceding claims, wherein the height of the auxiliary port is less than 20 mm.

7. The method of any one of the preceding claims, wherein the gas comprises ammonia.

8. The method of any one of the preceding claims, wherein the method comprises cooling the gas.

9. The method of any one of the preceding claims, wherein a standby gas flow through the auxiliary port is 5-10 liter per min.

10. The method of any one of the preceding claims, wherein a pressure in the pressurized zone is determined according to the height of the door of the chamber.

11. A system, comprising:
a chamber comprising a throat, a door, a target region, and a plurality of exhaust ports, wherein:
during a laser annealing process, the plurality of exhaust ports are open and the chamber is configured to generate a laminar flow of a gas across the target region, and
while the door is open, the plurality of exhaust ports are closed, a flow of the gas is increased, and the chamber is configured to generate a pressurized zone in the throat of the chamber, wherein:
the door of the chamber opens an auxiliary port,
the auxiliary port is perpendicular to the plurality of exhaust ports, and
a width of the auxiliary port is greater than a height of the auxiliary port.

12. The system of claim 11, wherein
a) the pressurized zone reduces oxygen ingress, and/or
b) the laminar flow comprises a velocity between 0.4 and 1.2 meters per second, and/or
c) the gas comprises ammonia, and/or
d) the chamber is configured to cool the gas, and/or
e) a standby gas flow through the auxiliary port is 5-10 liter per min, and/or
f) a pressure in the pressurized zone is determined according to the height of the door.

13. The system of claim 11 or 12, wherein the chamber comprises a plurality of inlet ports.

14. The system of any one of claims 11 to 13, wherein the system is configured for loading and/or unloading a semiconductor wafer while the door of the chamber is open.

15. The system of any one of claims 11 to 14, wherein the height of the auxiliary port is less than 20 mm.
